# EUROPEAN PATENT APPLICATION

(11) **EP 0 607 736 A1**
(43) Date of publication of application: **27.07.1994**
(21) Application number: 93500032.3
(22) Date of filing: 17.03.1993
(51) Int. Cl.: C23C 14/06, C23C 14/32

(54) **Process for obtaining carbon and metal-carbon coatings**

(30) Priority: 22.01.1993 ES 9300114
(71) Applicant: TEKNIKER, E-20600 Eibar (Guipuzcoa) (ES)
(72) Inventor: Laucirica, Javier, E-20600 Eibar, Guipuzcoa (ES); Alberdi, Alberto, E-20600 Eibar, Guipuzcoa (ES)
(74) Representative: Urizar Anasagasti, José Antonio

(57) **Abstract**

Process for obtainig carbon and carbon-metal coatings by means of physical deposition in vapor phase by means of electric arc with graphite cathode, in which the disposition of the electrode is that of arod surrounded by isolating rings of hexagonal boron nitride in such a way that the evaporation of the graphite electrode by means of electric arc generates a carbon plasma inside a vacuum chamber thus producing in this manner carbon coatings.

The process is divided into two stages as to the negative electric polarization, one of high polarization during the nucleation of the layer in order to improve adherence, and another of low polarization during the growth of the same in order to reduce internal tensions.

In the process, evaporated carbon produced from carbon graphite by means of electric arc is used as well as an evaporated metal by means of cathodic pulverization in order to syntheize carbon-metal coatings.

## Description

### INTRODUCTION

The "Diamond-like carbon" (DLC) or i-Carbon is a material constituted by the grouping of carbon atoms having a mixed electronic structure of bonds in hybridization sp² and sp³. It therefore has to do with a combination of short reaching structures which comprises the type of bonds that are characteristic of the two allotropic crystalline states of carbon: graphite and diamond.

The DLC coatings are chemically inert, having good resistance to chemical attacks and interesting electrical, micro-electrical and optical properties. As for mechanical properties, its high hardness and its low coefficient of friction are considerable. Both characteristics making it a material with excelent perspectives in anti-wearing applications, especially in charged contacts where fluid lubrication may result to be problematic or there may exist the risk of failure due to adhesion. Also as protecter coating for cutting tools, the DLC may be a good alternative in machining alloys which present problems of chemical affinity and solubleness with composites of titanium (TiN, TiC, TiCN, TiaN) being the ones mostly used for such an objective.

The adhesion and tenacity of such layers can be improved by adding to the pure carbon small quantities of metal. The carbon-metal coatings are not so extremely hard as those of pure carbon and are especially suitable for mechanical applications where layers of good resistance to wearing and certain capacity of deforming without breakage are required.

### BACKGROUND

The most widely applied technology up to this moment in order to synthesize "Diamond-like carbon" is the physical deposition in the vapor phase and aided by plasma (PACVD).

Such processes are carried out in vacuum chambers. The carbon is obtained from the decomposition of a hydrocarbon (acetylene, mathane, benzene, etc) activated by a plasma generated by means of discharges of direct current, radio-frequency or microwave.

The principal inconvenience of such technics is derived from the necessary closeness between electrods in order to maintain a stable plasma which constitutes a serious obstacle in achieving homegeneous coatings over three-dimensional objects. The technics of PACVD have permitted the synthesizing of carbon layers properly adhered over carbide, silicon or glass substrates. However the adherence on metalic objects is decreased in an alarming manner and results to be insufficient for many mechanical applications.

Carbon layers have also been obtained by employing the PVD-Sputtering technology. As in the previous case, these processes are carried out in vacuum chambers. The carbon is extracted by pulverization of a graphite cathode by means of bombardment with argon ions.

The synthesizing of carbon layers by PVD-Sputtering presents similar problems as those mentioned for the PACVD: difficulty in coating non-flat objects and bad adherence on metalic substrates.

### THE NEW PROCESS

A new process has been developed by TEKNIKER for synthesizing of carbon and carbon-metal coatings, which overcomes certain inconvenients of the PACVD and PVD-Sputtering technics, In said new process the coating material (solid) is synthesized starting from its constituents in vapor phase. The process is carried out in vacuum chamber and for synthesizing carbon-metal coatings, both the metal and the carbon are evaporated inside the chamber.

This new technic may be considered as included in the technologies of physical deposition in vapor phase (PVD), since the principal source of carbon is a graphite electrode. However, it is distinguished from the PVD-Sputtering processes because of the method employed for evaporation of graphite. In this new process cathodic pulverization is used for evaporation of the metal, and evaporation by electric arc is used in order to evaporate carbon.

In the cathodic pulverization a high negative voltage (over 400 V) with respect to the rest of the chamber, is applied to an electrode of the material which is desired to evaporate.

An inert gas (normally Ar) is introduced which due to the effect of the existing electric field is ionised, thus forming a plasma. The Ar+ ions present in the plasma are attracted by the negative electrode and bombard the surface of the electrode with high kinetic energy. As a consequence of this bombardment, the surface atoms are removed and a gas of a desired material is generated.

In order to accelerate the process, a permanent magnet or an electro-magnet is placed behind the electrode. The generated magnetic field helps to bring the Argon plasma close to the electrode, thus increasing the efficiency of the process.

In evaporation by arc as well, an electrode is used of the material to sublime, in this case graphite. The electric circuit is constituted by an exterior direct current power supply capable os supplying high intensity. The electrode to be evaporated acts as a cathode, and an anode (of for example copper) is placed in front of it at a distance of between 5 to 30 mm. The walls of the chamber are connected to earth.

The evaporation process starts by producing a short-circuit by means of a rod which is electrically connected to the anode and hits the cathode and later is removed. An electric arc is thus produced between the cathode and the anode which, if the pressure in the chamber is adequate, is indefinitely maintained. This electric arc of high intensity is concentrated at a point of the cathode and erodes its surface, thus generating a vapor of that material.

The evaporation technics by arc are employed in order to sublime a wide range of metals (Ti, Zr, Cr, etc.),. The novelty of this process is because it is employed in the evaporation of carbon from graphite. To that end a new electrode arrangement is designed: it deals with a graphite rod surrounded by isolating rings of hexagonal boron nitride.

A commercial evaporating system by cathodic arc may be used if precaution has been taken as to assuring the closeness of the arc in the graphite electrode by means of ceramic isolators.

It is a usual practice in PVD processes to establish a negative potential difference on the objects that are to be coated with recpect to the rest of the chamber which is connected to earth. In this manner, positive ions coming from the evaporators are attracted, and are given higher kinetic energy at the moment of reaching to the surface of the objects where the coating is being solidified.

Said additional energy given is very useful during the first moments of the process, when the coating is being nucleated, thus improving appreciably the adherence of the layer to the substrate. However, said bombardment with accelerated ions induces undesireable internal tensions on the layer. Both effects are critical in the case of carbon and carbon-metal coatings.

In this new process, the use of a constant polarization of the substrate during all the process does not serve. If said polarization is low, the layer will not adhere properly, however if it is very high, spontaneously fails due to internal tensions. The solution adopted is to divide the process into phases.

In a first phase of the process (optional), an ionic cleaning of the surface of the substrates with a very high polarization in an inert or reductor atmosphere is carried out. The second stage, nucleation of the layer, is carried out with high or medium polarization, and the third phase, growth of the layer, with low polarization.

The second critical point of the process is mixing of gases during the nucleation and growth phases of the layer. The working pressure in the chamber is controlled by means of an inert gas (Argon is used for economic reasons). Adding oxigen, hydrogen, nitrogen and carbonated gases (CO₂, CO, Hydrocarbons, etc) permit the modification of the hardness and tenacity properties of the coating. In this manner, choosing the adequate mixture of gases, a wide range of compounds can be synthetized, having a variety of characteristics depending on the type of applications which the coated objects are proposed to.

The layers of carbon and carbon-metal are not a unique product. It has to do with a whole family of coatings with different properties of hardness, tenacity, resistance to erosion or friction coefficients. For each use the most adequate one must be chosen.

All said different coatings are obtained following the same process, by only changing the mixture of gases which are present in the chamber and the metal provided.

The inert gas (normally argon) is the only gas totally necessary in the process. It has the fundamental mission of providing the plasma for avaporation of the metal of the cathodic pulverization. It is in addition in charge of maintaining the necessary conductivity for stablizing the carbon evaporator arc. This second function can be optionally carried out with nitrogen or a hydrocarbon. The rest of the gases are optional. A gas containing oxigen (O₂, CO₂ or CO) increases the velocity of the evaporation of carbon, but it should not be excessively used in order to avoid oxidation of the metal.

On the other hand, supplying hydrogen or a hydrocarbon improves the tenacity of the layer and partially reduces its hardness. They should be included in the mixture when the treated objects require such characteristics.

The process is very flexible as to the quantities of said gases present in the chamber. It is possible to work with total pressures starting from 0.1 Pa. until total pressures of various Pa. for each gas.

Dosing the quantity of the evaporated metal from the sputtering source, it is also possible to modify the properties of the coating: increase in the metalic quantity increases the tenacity and the adherence of the coating, but at the expense of reducing the hardness.

Therefore, the parameters which rule the process should vary in a wide range, depending on the properties of the coating which is desired to obtain in each case. In the following table general ranges of variation of the parameters of the process are specified.

**TABLE**

| PARAMETER | UNIT | RANGE OF VARIATION | | |
|---|---|---|---|---|
| | | 1st phase optional | 2nd phase | 3rd phase |
| electric intensity graphite arc | A | ------ | 10-500 | 10-500 |

| Partial pressures of the gases of the process: | | | | |
|---|---|---|---|---|
| * Inert gas (Ar) | | 0.1-100 | 0.1-50 | 0.1-50 |
| * H₂ | Pa | 0-50 | 0-20 | 0-20 |
| * O₂ | | ------ | 0-10 | 0-10 |
| * N₂ | | ------ | 0-50 | 0-50 |
| * CO₂6CO | | ------ | 0-20 | 0-20 |
| * Hydrocarbon (C₂H₂, CH₄...) | | ------ | 0-50 | 0-50 |
| Electric polarization of substrates | V | Maximum | 300-2000 | 0-300 |
| Specific power of metal source | W/Cm³ | ------ | 0-20 | 0-20 |

In short, the principal novelty of this process is based on the use of an electric arc in order to evaporate graphite. As a consequence of the high energy of the plasma of the carbon generated using this method, it is possible to synthesize hard layers of carbon with good adherence either on metalic or non-metalic substrates.

Regulating the composition of the atmosphere of the chamber, the electric polarization of substrates and the simultaneous supply of evaporated metal by means of "sputtering", it is possible to obtain a wide range of coatings of carbon and carbon-metal.

Having sufficiently described the nature of the present invention, as well as one way of putting it into practice, it only remains to be added that it is possible to introduce changes of form, materiales and disposition in the invention as a whole as well as in the parts it is composed of, as long as said alterations do not substantially vary the characteristics of the invention which are claimed as follows.

## Claims

1. Process for obtaining carbon and carbon-metal coatings by means of physical deposition in vapor phase by means of electric arc with graphite cathode, characterized in that the disposition of the electrode is that of a graphite rod surrounded by isolating rings of hexagonal boron nitride and in the evaporation by means of electric arc of a graphite electrode in order to generate a carbon plasma inside a vacumm chamber thus producing in this manner carbon coatings.

2. Process for obtaining carbon and carbon-metal coatings by means of physical deposition in vapor phase by means of electric arc with graphite cathode, according to the previous claim, characterized in that as to the negative polarization applied to the objects tobe coated, the process is divided into two stages, one of high polarization during the nucleation of the layer in order to improve the adherence, and another of low polarization during the growth of the same in order to reduce the internal tensions.

3. Process for obtaining carbon and carbon-metal coatings by means of physical deposition in vapor phase by means of electric arc with graphite cathode, according to claims 1 and 2, characterized in the simultaneous use of evaporated carbon by electric arc from a graphite electrode and an evaporated metal by cathodic pulverization in order to synthesize the carbon-metal coatings.

4. Process for obtaining carbon and carbon-metal coatings by means of physical deposition in vapor phase by means of electric arc with graphite cathode, according to the previous claims, characterized in the introduction of small quantities of a gas which contains oxigen, in the chamber during the process, in order to increase to growth velocity of the layer.
